Europäisches Patentamt

European Patent Office

Office européen des brevets

(19)

(11) **EP 1 737 125 A1**

(12) **DEMANDE DE BREVET EUROPEEN**

(43) Date de publication:
27.12.2006 Bulletin 2006/52

(51) Int Cl.:
*H03G 5/00* [(2006.01)]   *G06G 7/18* [(2006.01)]
*H03H 7/01* [(2006.01)]

(21) Numéro de dépôt: 06300266.1

(22) Date de dépôt: 22.03.2006

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **24.06.2005 FR 0506457**

(71) Demandeur: **Renault**
**92109 Boulogne Billancourt (FR)**

(72) Inventeurs:
• **Cordesses, Lionel**
**78180 Montigny-le-Bretonneux (FR)**
• **Marsilia, Marco**
**92130, ISSY LES MOULINEAUX (FR)**

(54) **Dispositif électronique analogique pour effectuer une dérivation temporelle filtrée d'un signal incident bruité**

(57) Le dispositif électronique analogique (1) est adapté pour effectuer une dérivation temporelle filtrée d'un signal incident bruité. Le dispositif comprend une pluralité de filtres analogiqucs ($F_1$, $F_2$, $F_3$), ainsi que des moyens de sélection (SEL) pour sélectionner l'un desdits filtres en fonction de l'amplitude des oscillations de la composante de bruit dudit signal incident.

# FIG.1

EP 1 737 125 A1

**Description**

La présente invention concerne un dispositif électronique analogique pour effectuer une dérivation temporelle filtrée d'un signal incident bruité, ainsi que le procédé associé.

L'obtention de la dérivée temporelle filtrée d'un signal incident bruité peut être nécessaire au fonctionnement d'un système.

Afin de pouvoir obtenir un signal dérivé exploitable, il est nécessaire d'effectuer un traitement permettant de réduire l'effet de la composante de bruit du signal incident.

Le document US 5 124 657 (Waller) décrit un circuit de réduction de bruit basé sur l'ajustement de la bande passante d'un filtre passe-bas. La fréquence de coupure du filtre passe-bas dépend du signal à traiter et ne tient pas compte de la composante de bruit de ce signal. En outre, ce dispositif n'effectue pas de dérivée filtrée du signal incident.

Le document US 4 647 876 (Waller) porte sur un système de réduction de bruit d'un signal. Ce document ne décrit pas de calcul de la dérivée filtrée d'un signal incident.

Le document US 5 263 091 (Waller) porte sur le conditionnement d'un signal d'entrée comprenant une composante de bruit.

De tels systèmes ont un coût relativement élevé.

Ainsi, l'invention propose de réaliser une dérivée filtrée d'un signal incident comprenant une composante de bruit, à coût faible au moyen d'électronique analogique, sans nécessiter la présence de microprocesseurs, ni de calculs numériques.

Aussi, selon un aspect de l'invention, il est proposé un dispositif électronique analogique pour effectuer une dérivation temporelle filtrée d'un signal incident bruité. Le dispositif comprend une pluralité de filtres analogiques. En outre, le dispositif comprend des moyens de sélection pour sélectionner l'un desdits filtres en fonction de l'amplitude des oscillations de la composante de bruit dudit signal incident.

Une telle réalisation étant purement analogique, celle-ci est réalisée à un faible coût, inférieur à celui de solutions mettant en oeuvre un processeur de traitement numérique de signal ou un microprocesseur. Un tel dispositif est très flexible et facile à mettre au point.

Un tel système fournit un signal de dérivée filtrée du signal incident, qui est exploitable et de bonne qualité.

Dans un mode de réalisation préféré, lesdits moyens de sélection comprennent des moyens de comparaison adaptés pour comparer l'amplitude des oscillations de la composante de bruit dudit signal incident avec des seuils prédéterminés.

Dans un mode de réalisation avantageux, le dispositif comprend des moyens de dérivation temporelle de signal, et des moyens de gain pour multiplier un signal par un gain prédéterminé.

En outre, le dispositif comprend trois filtres analogiques.

L'utilisation de trois filtres analogiques permet d'optimiser le coût de réalisation du dispositif par rapport au résultat obtenu. Il est cependant possible de réaliser l'invention avec deux filtres ou au moins quatre filtres.

Dans un mode de réalisation préféré, les moyens de sélection sont adaptés pour sélectionner le premier filtre lorsque ladite composante de bruit est croissante de croissance inférieure à un premier seuil prédéterminé, ou lorsque ladite composante de bruit est décroissante de décroissance inférieure à un deuxième seuil prédéterminé. Les moyens de sélection sont adaptés pour sélectionner le deuxième filtre lorsque ladite composante de bruit est croissante de croissance supérieure audit premier seuil, ou pour sélectionner le troisième filtre lorsque ladite composante de bruit est décroissante de décroissance supérieure audit deuxième seuil.

La sélection d'un des trois filtres est effectuée en fonction de l'amplitude des oscillations de la composante de bruit du signal incident.

Par exemple, les filtres sont des filtres passe-bas.

Dans un mode de réalisation préféré, le dispositif comprend un réseau résistif monté en série avec un condensateur. Le réseau résistif comprend trois branches montées en parallèle, la première branche comprenant une première résistance, la deuxième branche comprenant une deuxième résistance, et la troisième branche comprenant une troisième résistance. Dans le dispositif, le premier filtre comprend la première résistance et le condensateur, le deuxième filtre comprend le condensateur, la première résistance et la deuxième résistance, et le troisième filtre, comprend le condensateur, la première résistance et la troisième résistance.

Avantageusement, les moyens de sélection comprennent une première diode montée sur la deuxième branche entre la deuxième résistance et le condensateur, et une deuxième diode montée sur la troisième branche entre la troisième résistance et le condensateur. Les deux diodes sont montées dans le sens opposé.

Dans un mode de réalisation préféré, les moyens de gain comprennent un premier moyen d'amplification comprenant un premier amplificateur opérationnel connecté à l'entrée du réseau résistif, et recevant le signal incident sur l'entrée positive. Le premier amplificateur opérationnel comprend une boucle de rétroaction de la sortie sur l'entrée négative munie d'une quatrième résistance. Une cinquième résistance est disposée entre la masse et l'entrée négative du premier amplificateur opérationnel. Les moyens de gain comprennent en outre un deuxième moyen d'amplification comprenant un deuxième amplificateur opérationnel connecté au condensateur. Le deuxième amplificateur opérationnel a l'entrée positive reliée à la masse, l'entrée négative reliée au condensateur, et une boucle de rétroaction de la sortie sur l'entrée négative munie d'une sixième résistance.

En outre, lesdits moyens de dérivation temporelle de signal comprennent le condensateur et la sixième résistance.

Selon un autre aspect de l'invention, il est également proposé un procédé de dérivation temporelle filtrée d'un signal incident bruité, par filtrage analogique, dans lequel on filtre le signal incident en fonction de l'amplitude des oscillations de la composante de bruit dudit signal incident.

D'autres buts, caractéristiques et avantages de l'invention apparaîtront à la lecture de la description suivante, de quelques exemples nullement limitatifs, et faite en référence aux dessins annexés sur lesquels :

- la figure 1 est un schéma synoptique d'un mode de réalisation d'un dispositif selon un aspect de l'invention ;
- la figure 2 illustre un mode de réalisation d'un dispositif selon l'invention ;
- les figures 3, 4, 5 et 6 illustrent le fonctionnement du dispositif de la figure 2 lors des différentes sélections de filtres ;
- les figures 7, 8, 9 et 10 illustrent l'utilisation d'un dispositif selon la figure 2 appliquée à la dérivation d'un signal bruité d'un capteur d'accélération.

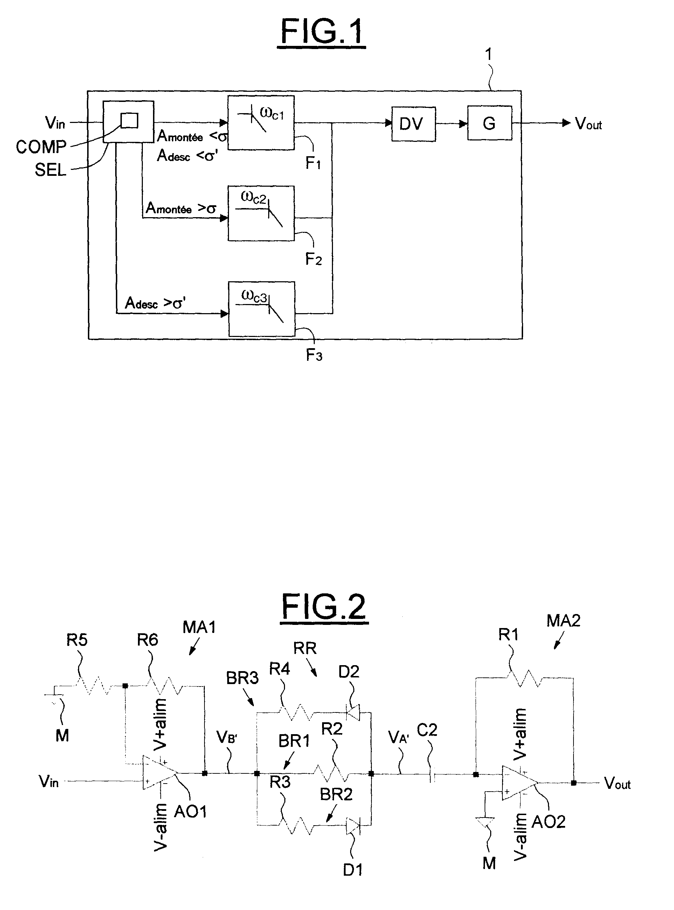

Sur la figure 1, le dispositif 1 comprend trois filtres analogiques passe-bas $F_1$, $F_2$ et $F_3$. Le dispositif électronique analogique 1 de dérivation temporelle filtrée comprend un module de sélection SEL pour sélectionner l'un des filtres $F_1$, $F_2$ ou $F_3$ en fonction de l'amplitude des oscillations de la composante de bruit du signal incident $V_{in}$.

Dans les exemples décrits, le nombre de filtres est égal à trois afin d'optimiser le coût de réalisation par rapport à la qualité du signal obtenu. Bien entendu, l'invention s'applique également au cas où le dispositif 1 comprend deux filtres, ou comprend un nombre de filtres supérieur ou égal à quatre.

Les moyens de sélection SEL comprennent des moyens de comparaison COMP adapté pour comparer l'amplitude des oscillations de la composante de bruit du signal incident $V_{in}$ avec des seuils prédéterminés σ et σ'. Le dispositif 1 comprend également un module de dérivation temporelle de signal DV, et un module de gain G pour multiplier un signal par un gain prédéterminé. Lorsque la composante de bruit du signal incident $V_{in}$ est décroissante $A_{desc}$, de décroissance supérieure au deuxième seuil σ', le module de sélection sélectionne le troisième filtre $F_3$.

Lorsque la composante de bruit du signal incident $V_{in}$ est croissante $A_{montée}$, le module de sélection sélectionne le deuxième filtre $F_2$.

Dans les autres cas, le module de sélection SEL sélectionne le premier filtre $F_1$. En d'autres termes, le module de sélection SEL sélectionne le premier filtre $F_1$ lorsque la composante de bruit du signal incident $V_{in}$ est croissante à $A_{montée}$ de croissance inférieure au premier seuil σ, ou lorsque la composante de bruit du signal incident $V_{in}$ est décroissante $A_{desc}$ de décroissance inférieure au deuxième seuil σ'.

En sortie du dispositif 1, on obtient un signal de sortie $V_{out}$ qui est la dérivée filtrée du signal incident $V_{in}$.

Sur la figure 2 est représenté un exemple de réalisation du dispositif de la figure 2. Le dispositif 1 comprend un réseau résistif RR monté en série avec un condensateur C2. Le réseau résistif RR comprend trois branches BR1, BR2 et BR3 montées en parallèle. La première branche BR1 comprend une première résistance R2, la deuxième branche BR2 comprend une deuxième résistance R3, et la troisième branche BR3 comprend une troisième résistance R4.

Le premier filtre $F_1$ comprend la première résistance R2 et le condensateur C2.

Le deuxième filtre $F_2$ comprend le condensateur C2, la première résistance R2 et la deuxième résistance R3.

Le troisième filtre $F_3$ comprend le condensateur C2, la première résistance R2 et la troisième résistance R4.

Le module de sélection SEL comprend une première diode D1 montée sur la deuxième branche BR2 entre la deuxième résistance R3 et le condensateur C2, et comprend une deuxième diode D2 montée sur la troisième branche BR3 entre la troisième résistance R4 et le condensateur C2. Les deux diodes D1 et D2 sont montées en sens opposés.

Le module de gain G comprend un premier module d'amplification MA1 et un second module d'amplification MA2.

Le premier module d'amplification MA1 comprend un premier amplificateur opérationnel AO1 connecté à l'entrée du réseau résistif RR et recevant le signal incident $V_{in}$ sur l'entrée positive. Une boucle de rétroaction de la sortie sur l'entrée négative du premier amplificateur opérationnel AO1 est munie d'une quatrième résistance R6. Une cinquième résistance R5 est disposée entre la masse M et l'entrée négative du premier amplificateur opérationnel AO1.

Le deuxième module d'amplification MA2 comprend un deuxième amplificateur opérationnel AO2 connecté au condensateur C2 et ayant l'entrée positive reliée à la masse M. L'entrée négative du deuxième amplificateur opérationnel AO2 est reliée au condensateur C2. Une boucle de rétroaction de la sortie sur l'entrée négative du deuxième amplificateur opérationnel AO2 est munie d'une sixième résistance R1.

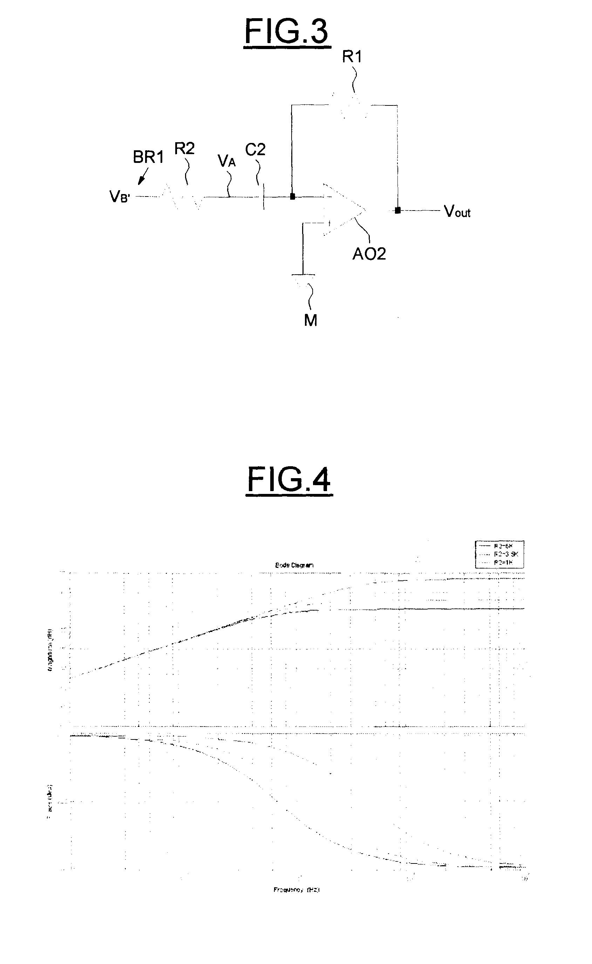

La figure 3 représente le cas dans lequel le premier filtre $F_1$ est sélectionné. Les diodes $D_1$ et $D_2$ sont alors non passantes.

La figure 4 illustre les diagrammes de Bode du module et de la phase correspondant au circuit de la figure 3 pour différentes valeurs de la première résistance R2.

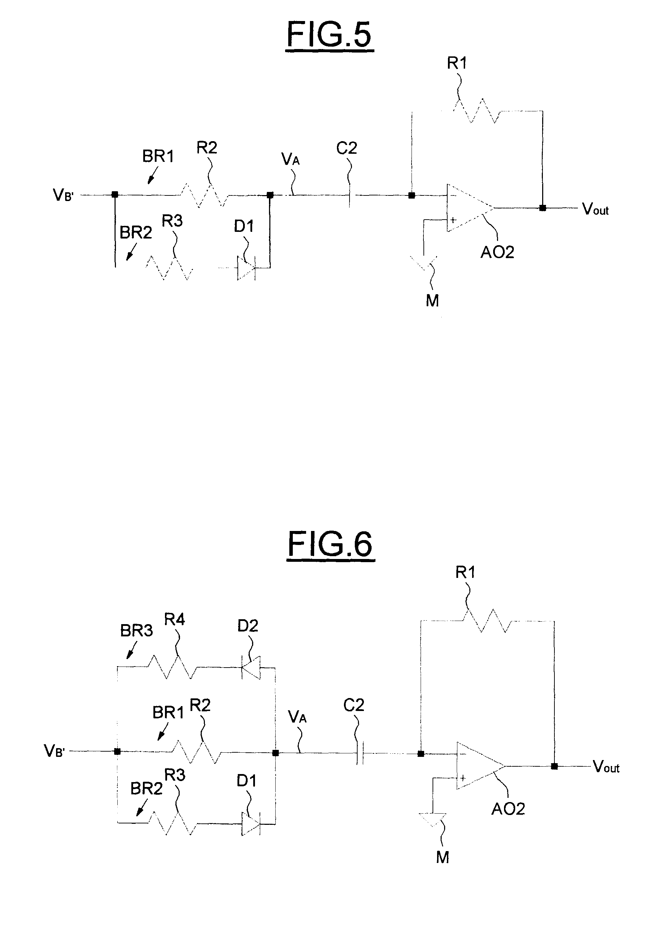

La figure 5 illustre le circuit de la figure 2 dans lequel le deuxième filtre $F_2$ est sélectionné.

La figure 6 illustre le circuit de la figure 2 dans lequel le troisième filtre $F_3$ est sélectionné.

On explicite maintenant le fonctionnement du circuit de la figure 2.

L'étude de la figure 3 nous donne une équation de transfert transformée dans le plan complexe :

$$\frac{V_{out}}{V_{B'}} = -\frac{R1}{R2 + \frac{1}{s\,C2}} = -\frac{s\,R1C2}{1 + s\,C2R2} \qquad (1)$$

Le circuit présente une racine à fréquence nulle, représentative d'une action dérivatrice, et un pôle de pulsation :

$$\omega_p = \frac{1}{C2R2} \qquad (2)$$

La figure 4 illustre des diagrammes de Bode du module et de la phase du circuit de la figure 3 pour différentes valeurs de la première résistance R2.

On également :

$$\frac{V_{out}}{V_A} = -s\,C2R1 \qquad (3)$$

L'équation (3) écrite sous forme temporelle est la suivante :

$$V_{out} = -C2R2\frac{dV_A}{dt} \qquad (4)$$

La combinaison des équations (1) et (3) donne :

$$\frac{V_A}{V_{in}} = \frac{1}{1 + s\,C2R2} \qquad (5)$$

Le signal $V_A$ correspond au signal $V_{in}$ filtré par un filtre passe-bas du premier ordre de pulsation de coupure $\omega_{c1}$ a -3dB donné par l'équation suivante :

$$\omega_{c1} = \omega_p = \frac{1}{C2R2} \qquad (6)$$

La figure 5 représente le cas dans lequel la diode D2 de la figure 2 est bloquée. Lorsque la diode D1 est bloquée, le circuit de la figure 5 est équivalent au circuit de la figure 3. Lorsque la diode D1 est active ou passante, la deuxième résistance R3 est en parallèle avec la première résistance R2 et la résistance équivalente correspondante est inférieure à la valeur de la première résistance R2. Le pôle de la fonction de transfert dans le plan complexe de ce circuit est alors de fréquence plus élevée. En réalité les deux résistances R2 et R3 ne sont pas vraiment en parallèle, car la chute de tension aux bornes de la diode D1 n'est pas nulle. Cependant les raisonnements précédents restent valables.

En notant $V_{seuil}$ la tension de seuil de la diode D1, la diode D1 est bloquée ou non-passante tant que :

$$e = V_{in} - V_A < V_{seuil} \qquad (7)$$

et devient active ou passante lorsque :

$$e > V_{seuil}. \qquad (8)$$

Le signal $e = V_{in} - V_A$ représente, pour l'équation (5), l'erreur entre le signal d'entrée $V_{in}$ et le signal filtré passe-bas $V_A$.

La tension électrique $V_A$. du circuit de la figure 5 correspond au signal d'entrée $V_{in}$ filtré passe-bas par un filtre du premier ordre de pulsation de coupure $\omega_{C1}$ tant que e reste inférieur à $V_{seuil}$ et par un filtre du premier ordre de pulsation de coupure $\omega_{C2}$ supérieure à $\omega_{C1}$ quand e est supérieur à $V_{seuil}$. La présence de la diode $D_1$ dans le circuit introduit donc une non-linéarité dans le filtrage du signal d'entrée $V_{in}$.

En sortie du circuit de la figure 5 on récupère la dérivée du signal $V_A$, ainsi obtenu (équation (4)).

Le signal d'erreur e est directement lié à l'amplitude des oscillations de la composante de bruit du signal électrique d'entrée $V_{in}$. Pour l'équation (8), la non-linéarité introduite par la diode $D_1$ est effective (diode passante) lorsque l'erreur e est positive (le signal monte) et supérieur au seuil $V_{seuil}$. La bande passante du filtrage est ainsi augmentée afin de conserver l'information liée à la montée haute fréquence de grande amplitude du signal $V_{in}$.

Le circuit de la figure 6 présente une deuxième diode D2. Soit $V'_{seuil}$ la tension de seuil de cette dernière, elle est alors bloquée tant que :

$$e = V_{in} - V_A > -V'_{seuil} \qquad (9)$$

et devient active lorsque :

$$e < -V_{seuil}. \qquad (10)$$

La troisième résistance R4 est alors en parallèle avec la première R2 et, par conséquent, le pôle du circuit a une fréquence plus élevée. Cela permet d'augmenter la bande passante du filtrage afin de conserver l'information liée à la descente (e<0) haute fréquence de grande amplitude de la composante de bruit du signal $V_{in}$.

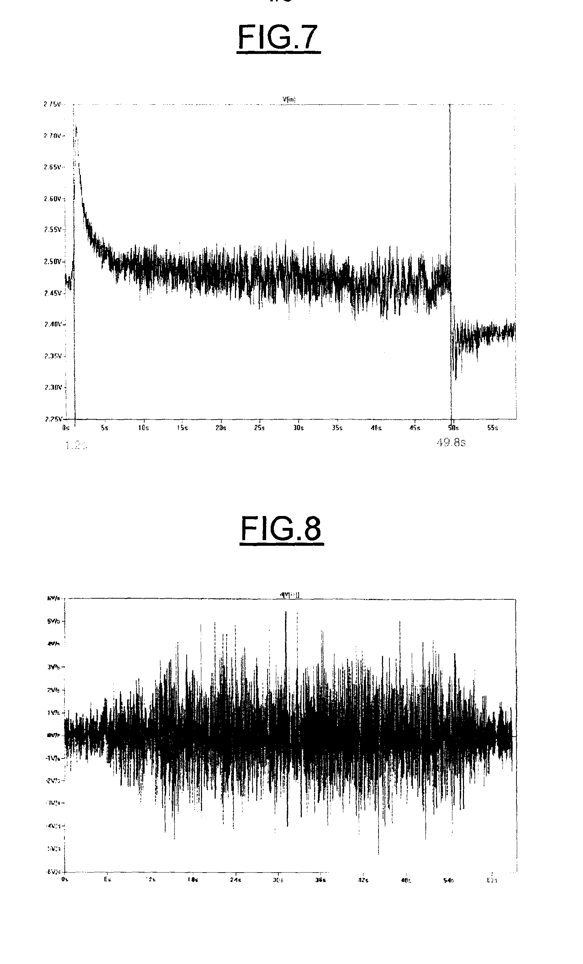

Le circuit de la figure 2 diffère du circuit de la figure 6 par la présence du premier module d'amplification MA1 (figure 7). La fonction de transfert de ce dernier est donnée par l'équation :

$$A_v = \frac{V_{B'}}{V_{in}} = 1 + \frac{R6}{R5} \qquad (11)$$

dans laquelle $V_B$, représente la tension électrique entre la sortie du premier module d'amplification MA1 et l'entrée du réseau résistif RR du circuit de la figure 1.

Le premier module d'amplification MA1 permet de gérer des non-linéarités introduites par les diodes D1 et D2. En effet, l'équation (5) devient pour le circuit de la figure 2 :

$$V_{A'} = V_{B'} \cdot \frac{1}{1 + s\,C2R2} \qquad (12)$$

Des équations (5), (11) et (12), on déduit :

$$V_{A'} = A_V \cdot V_{in} \cdot \frac{1}{1 + s\,C2R2} = A_V \cdot V_A \qquad (13)$$

La diode $D_1$ est alors bloquée tant que :

$$V_{B'} - V_{A'} = A_V \cdot (V_{in} - V_A) = A_V \cdot e < V_{seuil} \Rightarrow e < \frac{V_{seuil}}{A_V} = a \quad avec \ a \in R^+ \qquad (14)$$

et devient passante lorsque :

$$e > \frac{V_{seuil}}{A_V} = a \qquad (15)$$

La diode $D_2$ est bloquée tant que :

$$A_V \cdot e > -V'_{seuil} \Rightarrow e > -\frac{V'_{seuil}}{A_V} = -b \qquad avec \ b \in R^+ \qquad (16)$$

et devient passante lorsque :

$$e < -b. \qquad (17)$$

Ainsi, à l'aide du gain $A_V$ du premier étage d'amplification d'entrée $MA_1$, la valeur des seuils a et b sur l'erreur e, au-delà desquels la bande passante du filtrage augmente, peut être réglée.

Le gain G du circuit de la figure 2 reste le même en fonctionnement linéaire et non-linéaire, et vaut :

$$G = A_V \cdot R1.C2 = \left(1 + \frac{R6}{R5}\right).R1.C2 \qquad (18)$$

G correspond au gain par lequel sera multiplié le signal incident.

La fonction de transfert du premier module d'amplification $MA_1$ est donnée par l'équation suivante :

$$\frac{V_{B'}}{V_{in}} = 1 + \frac{R6}{R5} = A_V \qquad (19)$$

le gain $A_v$ (et donc les valeurs des résistances R5 et R6) est choisi de façon à obtenir les seuils $\sigma$ et $\sigma'$ souhaités.

En fonctionnement linéaire, lorsque les deux diodes D1 et D2 sont bloquées, la fonction de transfert du circuit de la figure 6 est donnée par l'équation :

$$\frac{V_{out}}{V_{in}} = -\frac{s\,R1C2}{1 + s\,C2R2} \qquad (20)$$

La première résistance $R_2$ est choisie de manière à obtenir la pulsation de coupure $\omega_{c1}$ du premier filtre $F_1$ telle que :

$$\omega_{c1} = \frac{1}{C2R2}. \qquad (21)$$

La valeur de la deuxième R3 est calculée de manière à obtenir la pulsation de coupure $\omega_{c2}$ du deuxième filtre $F_2$ en négligeant la chute de tension aux bornes de la diode D1 :

$$\omega_{c2} = \frac{1}{C2(R2\,/\!/\,R3)} = \frac{R2 + R3}{C2R2R3} \qquad (22)$$

La valeur de la deuxième résistance R3 est ensuite ajustée de manière à satisfaire les contraintes imposées.
La valeur de la troisième résistance R4 est tout d'abord calculée de manière à obtenir $\omega_{c3}$ en négligeant la chute de tension aux bornes de la diode D2 :

$$\omega_{c3} = \frac{1}{C2(R2\,/\!/\,R4)} = \frac{R2 + R4}{C2R2R4} \qquad (23)$$

La valeur de la sixième résistance R1 est choisie de manière à obtenir le gain de sortie du système G voulu (figure 7). En effet, modifier la valeur de la sixième résistance R1 permet de changer le gain G du système (équation (18)) sans pour autant modifier les pulsations de coupure $\omega_{c1}$, $\omega_{c2}$ et $\omega_{c3}$ du système (équations (21), (22) et (23)).
L'invention permet d'obtenir un signal dérivé filtré d'un signal électrique bruité. On peut, par exemple, appliquer l'invention à l'estimation du "jerk" ou dérivée de l'accélération fournie par un capteur d'accélération d'un véhicule automobile.
Un tel capteur fournit une tension électrique analogique représentative de l'accélération du véhicule. Cette tension électrique est utilisée comme signal incident bruité.
Un exemple représentatif du signal d'un capteur d'accélération est représenté sur la figure 7. Les oscillations présentes dans ce signal ne correspondent pas à des variations de l'accélération du véhicule, elles sont dues au bruit de mesure du capteur. Par contre, la forte montée à t= 1.2 s, et la forte descente à t= 49.8 s correspondent à des variations réelles de l'accélération du véhicule.
La figure 8 représente le signal de dérivée du signal de figure 7 obtenu sans mettre en oeuvre l'invention en dérivant directement le signal incident. Sur cette figure, on remarque que l'évaluation du "jerk" à partir du signal d'accélération de la figure 7 n'est pas possible à cause de la composante de bruit présente dans ce signal.

L'invention permet de réduire l'amplitude des oscillations correspondant au bruit tout en gardant les pentes (la dérivée) du signal aux instants correspondants aux descentes et aux montées de grande amplitude (à t=1.2s et t=49.8s sur la figure 7) du signal d'accélération.

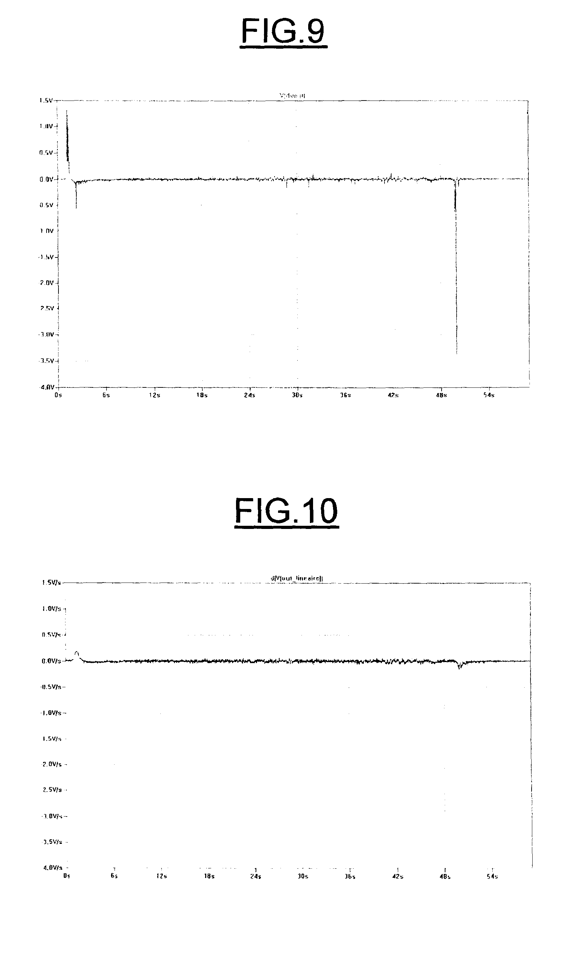

Le signal du capteur d'accélération représenté sur la figure 7 et traité par le circuit de la figure 2 donne pour le signal résultant le signal représenté sur la figure 9.

La figure 10 illustre enfin le signal de dérivée du signal obtenu en filtrant passe-bas avec un filtre du premier ordre le signal d'accélération de la figure 7. La figure 10 prouve qu'avec une solution par filtrage linéaire et dérivation, on élimine le bruit présent dans le signal d'origine mais on perd toute information utile concernant le jerk (à t=1.2s et t=49.8s). Au contraire le signal d'accélération traité par l'invention est purgé du bruit de mesure et garde bien l'information utile concernant le jerk de la voiture aux instants t=1.2s et t=49.8s (figure 9).

**Revendications**

1. Dispositif électronique analogique (1) pour effectuer une dérivation temporelle filtrée d'un signal incident bruité, comprenant une pluralité de filtres analogiques ($F_1$, $F_2$, $F_3$), **caractérisé par le fait qu'**il comprend des moyens de sélection (SEL) pour sélectionner l'un desdits filtres en fonction de l'amplitude des oscillations de la composante de bruit dudit signal incident.

2. Dispositif selon la revendication 1, dans lequel, lesdits moyens de sélection (SEL) comprennent des moyens de comparaison (COMP) adaptés pour comparer l'amplitude des oscillations de la composante de bruit dudit signal incident avec des seuils prédéterminés ($\sigma$, $\sigma'$).

3. Dispositif selon la revendication 1 ou 2, comprenant, en outre, des moyens de dérivation temporelle (DV) de signal, et des moyens de gain (G) pour multiplier un signal par un gain prédéterminé.

4. Dispositif selon la revendication 3, comprenant trois filtres analogiques ($F_1$, $F_2$, $F_3$).

5. Dispositif selon la revendication 4, dans lequel :

   les moyens de sélection (SEL) sont adaptés pour sélectionner le premier filtre ($F_1$) lorsque ladite composante de bruit est croissante de croissance inférieure à un premier seuil prédéterminé ($\sigma$), ou lorsque ladite composante de bruit est décroissante de décroissance inférieure à un deuxième seuil prédéterminé ($\sigma'$) ;
   les moyens de sélection (SEL) sont adaptés pour sélectionner le deuxième filtre ($F_2$) lorsque ladite composante de bruit est croissante de croissance supérieure audit premier seuil ; ou
   les moyens de sélection sont adaptés pour sélectionner le troisième filtre lorsque ladite composante de bruit est décroissante de décroissance supérieure audit deuxième seuil ($\sigma$).

6. Dispositif selon la revendication 5, dans lequel lesdits filtres ($F_1$, $F_2$, $F_3$) sont des filtres passe-bas.

7. Dispositif selon la revendication 6, comprenant un réseau résistif (RR) monté en série avec un condensateur (C2), ledit réseau résistif (RR) comprenant trois branches (BR1, BR2, BR3) montées en parallèle, la première branche (BR1) comprenant une première résistance (R2), la deuxième branche (BR2) comprenant une deuxième résistance (R3), et la troisième branche (BR3) comprenant une troisième résistance (R4), et dans lequel, ledit premier filtre ($F_1$) comprend ladite première résistance (R2) et ledit condensateur (C2), ledit deuxième filtre ($F_2$) comprend ledit condensateur (C2), la première résistance (R2) et la deuxième résistance (R3), et ledit troisième filtre ($F_3$) comprend le condensateur (C2), la première résistance (R2) et la troisième résistance (R4).

8. Dispositif selon la revendication 7, dans lequel lesdits moyens de sélection (SEL) comprennent une première diode (D1) montée sur la deuxième branche (BR2) entre la deuxième résistance (R3) et le condensateur (C2), et une deuxième diode (D2) montée sur la troisième branche (BR3) entre la troisième résistance (R4) et le condensateur (C2), les deux diodes (D1, D2) étant montées en sens opposés.

9. Dispositif selon la revendication 7 ou 8, dans lequel lesdits moyens de gain (G) comprennent :

   un premier moyen d'amplification (MA1) comprenant un premier amplificateur opérationnel (AO1) connecté à l'entrée dudit réseau résistif (RR) et recevant ledit signal incident sur l'entrée positive, ayant une boucle de rétroaction de la sortie sur l'entrée négative munie d'une quatrième résistance (R6), et ayant une cinquième résistance (R5) disposée entre la masse (M) et l'entrée négative ; et

un deuxième moyen d'amplification (MA2) comprenant un deuxième amplificateur opérationnel (AO2) connecté au condensateur (C2), ledit deuxième amplificateur opérationnel (AO2) ayant l'entrée positive reliée à la masse (M), l'entrée négative reliée au condensateur (C2), et ayant une boucle de rétroaction de la sortie sur l'entrée négative munie d'une sixième résistance (R1).

10. Dispositif selon l'une quelconque des revendications 7 à 9, dans lequel lesdits moyens de dérivation temporelle de signal comprennent le condensateur (C2) et la sixième résistance (R1).

11. Procédé de dérivation temporelle filtrée d'un signal incident bruité, par filtrage analogique, **caractérisé par le fait que** l'on filtre ledit signal incident en fonction de l'amplitude des oscillations de la composante de bruit dudit signal incident.

# FIG.1

# FIG.2

# FIG.3

# FIG.4

## FIG.5

## FIG.6

## FIG.7

## FIG.8

# FIG.9

# FIG.10

Office européen
des brevets

**RAPPORT DE RECHERCHE EUROPEENNE**

Numéro de la demande

EP 06 30 0266

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 3 470 367 A (CLINTON D. FRISBY ET AL) 30 septembre 1969 (1969-09-30) * colonne 13, ligne 40 - colonne 14, ligne 15; figure 3 * ----- | 1,11 | INV. H03G5/00 G06G7/18 H03H7/01 |
| D,A | US 5 124 657 A (WALLER, JR. ET AL) 23 juin 1992 (1992-06-23) * abrégé * ----- | 1 | |
| D,A | US 4 647 876 A (WALLER, JR. ET AL) 3 mars 1987 (1987-03-03) * colonne 2, ligne 3 - ligne 55 * ----- | 1 | |
| A | US 5 212 829 A (BRINKHAUS ET AL) 18 mai 1993 (1993-05-18) * colonne 2, ligne 52 - colonne 4, ligne 42; figures 2,3 * ----- | 1 | |
| A | GB 1 506 856 A (IRD MECHANALYSIS INC) 12 avril 1978 (1978-04-12) * page 1, ligne 50 - page 2, ligne 54 * ----- | 1 | **DOMAINES TECHNIQUES RECHERCHES (IPC)** H03G G06G H03H |

Le présent rapport a été établi pour toutes les revendications

| Lieu de la recherche | Date d'achèvement de la recherche | Examinateur |
|---|---|---|
| La Haye | 3 octobre 2006 | Blaas, Dirk-Luetjen |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

...................................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 06 30 0266

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-10-2006

| Document brevet cité au rapport de recherche | | Date de publication | Membre(s) de la famille de brevet(s) | | Date de publication |
|---|---|---|---|---|---|
| US 3470367 | A | 30-09-1969 | CH<br>DE<br>GB | 492199 A<br>1549624 A1<br>1204509 A | 15-06-1970<br>03-06-1971<br>09-09-1970 |
| US 5124657 | A | 23-06-1992 | AUCUN | | |
| US 4647876 | A | 03-03-1987 | AUCUN | | |
| US 5212829 | A | 18-05-1993 | DE<br>EP | 4105123 A1<br>0500037 A2 | 27-08-1992<br>26-08-1992 |
| GB 1506856 | A | 12-04-1978 | CA<br>DE<br>FR<br>FR<br>FR<br>FR<br>FR<br>JP<br>US | 1035047 A1<br>2456593 A1<br>2253317 A1<br>2253321 A1<br>2253313 A1<br>2253318 A1<br>2253210 A1<br>50094986 A<br>3938394 A | 18-07-1978<br>05-06-1975<br>27-06-1975<br>27-06-1975<br>27-06-1975<br>27-06-1975<br>27-06-1975<br>29-07-1975<br>17-02-1976 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5124657 A, Waller
- US 4647876 A, Waller
- US 5263091 A, Waller